# EUROPEAN PATENT SPECIFICATION

(11) **EP 1 856 217 B1**
(45) Date of publication and mention of the grant of the patent: **18.08.2010**
(21) Application number: 06735215.3
(22) Date of filing: 16.02.2006
(51) Int. Cl.: C09D 11/00, C09D 163/00, C07D 317/36

(54) **ENERGY-CURABLE COATING COMPOSITIONS**
ENERGIEHÄRTBARE BESCHICHTUNGSZUSAMMENSETZUNGEN
COMPOSITIONS DE REVÊTEMENT DURCISSABLES PAR ÉNERGIE

(30) Priority: 25.02.2005 GB 0503953
(43) Date of publication of application: 21.11.2007
(73) Proprietor: Sun Chemical Corporation, Parsippany, NJ 07054 (US)
(72) Inventor: HERLIHY, Shaun, Lawrence, Walderslade, Chatham Kent ME5 9DD (GB); STANDING, Stephen, Stuart, Orpington Kent BR6 6BD (GB); DAVIDSON, Robert, Stephen, Leicester LE5 2GG (GB)
(74) Representative: Grosse, Rainer
(86) International application number: PCT/US2006/005444
(87) International publication number: WO 2006/093679

(56) References cited:
- WO-A-02/42383
- WO-A-92/04383
- US-A- 5 262 449

## Description

The present invention relates to new energy-curable coating compositions, such as printing inks or varnishes, having excellent cure and, if desired, a relatively low viscosity, as a result of the incorporation in the composition of unprecedentedly high levels of cyclic carbonates, which seems to result in a synergistic interaction between the cyclic carbonate, and an epoxide monomer or oligomer and a multi-functional oxetane, resulting in enhanced cure speed and post-cure.

Although cationic curing of printing inks on exposure to ultraviolet radiation (UV) by the ring-opening polymerisation of epoxides has been known for a very long time, it has never achieved much commercial success, as a result, *inter alia*, of the slow cure speed of such systems. In order to make such systems commercially attractive, it is necessary to improve the cure speed of UV cationically curable epoxide-based printing inks and similar coating compositions.

We have surprisingly found that this may be achieved by the incorporation in the coating composition of relatively high levels of one or more cyclic carbonates, such as propylene carbonate, together with an epoxide monomer or oligomer and a multi-functional oxetane. This finding is the more surprising, since propylene carbonate, in particular, is commonly used as a solvent for the cationic photoinitiator in such systems (the cationic photoinitiator commonly being used as a 50% solution in propylene carbonate) and since there is pressure from users of these coating compositions to reduce the level of propylene carbonate, on the basis that it may migrate out of the cured composition. Moreover, propylene carbonate is deemed by most formulators and end users to be an unreactive component, and so it would not be expected to have a positive effect on cure. Indeed, US Patent No. 5,262,449 is not alone in stating specifically that simple alkylene carbonates are merely solvents and play no part in polymerisation, and that they should be used in relatively low amounts to avoid undesired effects.

Since the level of propylene carbonate in prior art compositions is determined by the level of cationic photoinitiator, it is readily possible to determine the levels of propylene carbonate in the resulting compositions. In general, sulphonium salt cationic photoinitiators have been used in the prior art at levels of from 8 to 10% by weight, and so the level of propylene carbonate in such compositions would be from 4 to 5% by weight.

Carroy ["New Developments in Cationic Curing Flexo Inks", a paper presented at RadTech e/5 2004 Technical Proceedings] discloses a composition containing about 13.4% propylene carbonate, but attributes the results he achieved to the excellent thioxanthonium cationic photoinitiator which he used and its good dissolution in the printing ink.

JP 2004-32361 (Konica Minolta) also discloses a coating composition for ink jet use that contains either a cyclic ester compound (in an amount between 2.5 and 20 mass%, preferably between 5.0 and 15 mass%, of the total ink mass) or propylene carbonate (in unspecified amounts).

In accordance with the present invention, we have found that significantly higher levels of a cyclic carbonate, such as propylene carbonate, than are conventionally used are needed in order to achieve the desired enhanced cure speed and post-cure.

Thus, in one aspect, the present invention consists in an energy-curable coating composition comprising an epoxide monomer or oligomer, a multifunctional oxetane, a cationic photoinitiator and a cyclic carbonate, the cyclic carbonate being present in an amount of at least 12% by weight of the entire composition.

In a further aspect, the present invention consists in an energy-curable coating composition comprising an epoxide monomer or oligomer, a multifunctional oxetane, a cationic photoinitiator and a cyclic carbonate other than propylene carbonate.

In a still further aspect, the present invention consists in an energy-curable coating composition comprising an epoxide monomer or oligomer, a multifunctional oxetane, a cationic photoinitiator and a cyclic carbonate, the cyclic carbonate being present in an amount of from 15% to 35% by weight of the entire composition.

Surprisingly, we discovered that the use of a cyclic carbonate in an amount in excess of that previously used would lead to enhanced cure speed and post-cure. More surprisingly, in accordance with the present invention, we have found that there is a synergistic effect when such an increased level of cyclic carbonate is used together with an epoxide and a multi-functional oxetane, and that this synergistic effect leads to substantially better results than are achieved using lower levels of cyclic carbonate, and better results than are achieved when using the high levels of cyclic carbonate required by the present invention, but together with an epoxide and a mono-oxetane.

Typical epoxides which may be used include the cycloaliphatic epoxides (such as those sold under the designations Cyracure UVR6105, UVR6107, UVR6110 and UVR6128, by Dow), which are well known to those skilled in the art.

Other epoxides which may be used include such epoxy-functional oligomers/monomers as the glycidyl ethers of polyols [bisphenol A, alkyl diols or poly(alkylene oxides), which be di-, tri-, tetra- or hexa- functional]. Also, epoxides derived by the epoxidation of unsaturated materials may also be used (e.g. epoxidised soybean oil, epoxidised polybutadiene or epoxidised alkenes). Naturally occurring epoxides may also be used, including the crop oil collected from Vernonia galamensis.

A variety of oxetane compounds is available for use in the compositions of the present invention. For example, one such class of compounds are those compounds of formula (I): 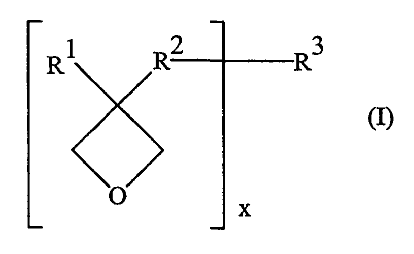 in which:
R¹ represents a hydrogen atom, a C₁ - C₆ alkyl group, an aryl group or an aralkyl group;
R² represents a direct bond or a C₁ - C₆ alkylene group;
R³ represents the residue of a polyol; and
x is a number from 2 to 6.

In the compounds of formula (I), x is more preferably from 2 to 4, still more preferably x is 2.

A further class of oxetane compounds which may be used in the compositions of the present invention are those compounds of formula (II): 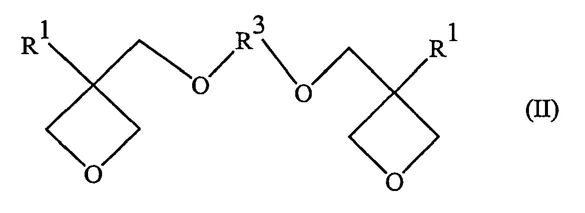 in which:
R¹ represents a hydrogen atom, a C₁ - C₆ alkyl group, an aryl group or an aralkyl group, and the two groups R¹ may be the same as or different from each other; and
R³ represents a C₁ - C₁₂ alkylene group, a C₂ - C₁₂ alkenylene group, a poly(alkyleneoxy) group, a carbonyl group, a C₂ - C₁₂ alkylene group in which a methylene group is replaced by a carbonyl group, an aryl group.

In the compounds of formula (II), we prefer that R³ should represent a C₁ - C₆ alkylene group.

A further class of oxetane compounds which may be used in the compositions of the present invention are those compounds of formula (III): 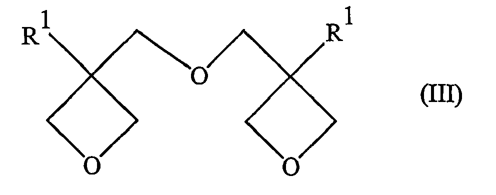 in which R¹ represents a hydrogen atom, a C₁ - C₆ alkyl group, an aryl group or an aralkyl group, and the two groups R¹ may be the same as or different from each other.

A particularly preferred example of the compounds of formula (III) is bis[(1-ethyl-3-oxetanyl)methyl] ether.

A further class of oxetane compounds which may be used in the compositions of the present invention are those compounds formula (IV): 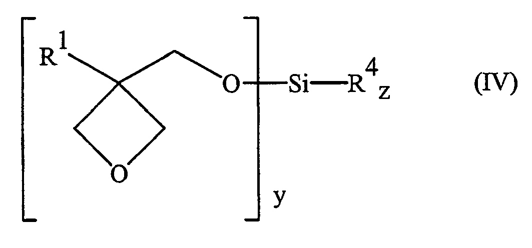
R¹ represents a hydrogen atom, a C₁ - C₆ alkyl group, an aryl group or an aralkyl group;
R⁴ represents a group of formula -O-R⁵ or a group R⁶;
R⁵ represents a C₁ - C₂₀ alkyl group, a C₂ - C₂₀ alkenyl group, an aryl group, an aralkyl group, a polyalkylene oxide group or a poly(lactone) group;
R⁶ represents a C₁ - C₂₀ alkyl group, an aryl group or an aralkyl group;
y is a number greater than 1 and no greater than 4; and
(y+z)=4.

Particularly preferred compounds of formula (IV) include the compounds of formula (V): 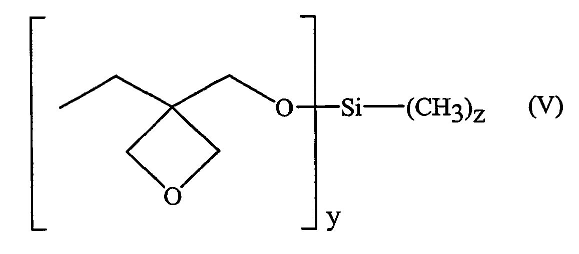 where y is a number of at least 2 and no greater than 4 and z is (4-y).

Compounds of formula (IV) and (V) are disclosed in GB 2393444, the disclosure of which is incorporated herein by reference.

Other examples of oxetane compounds which may be used in the present invention include compounds of formula (VI): 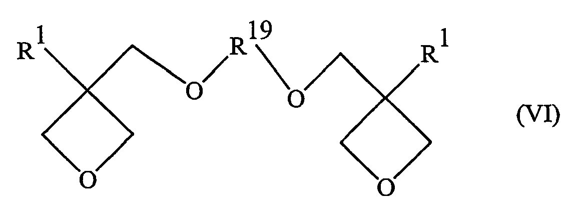 in which R¹⁹ represents a group of formula (VII), (VIII), or (IX) or a carbonyl group: 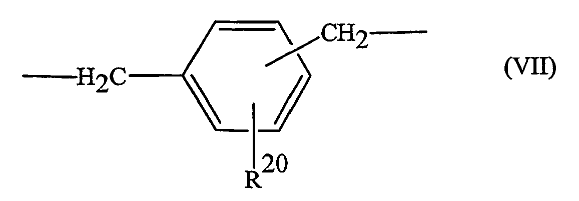 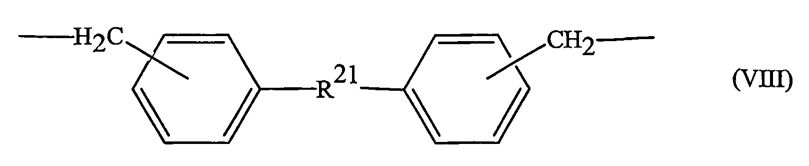 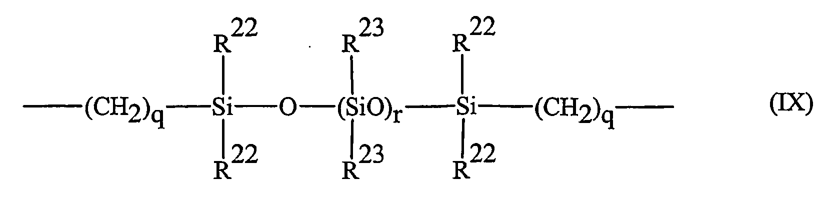 in which:
R²⁰ represents a C₁ - C₄ alkyl group (e.g. methyl, ethyl, propyl or butyl), a C₁ - C₄ alkoxy group (e.g. methoxy, ethoxy, propoxy or butoxy), a halogen atom (e.g. chlorine or bromine), a nitro group, a cyano group, a mercapto group, a C₁ - C₄ alkylthio group,
a carboxy group, a C₂ - C₅ alkoxycarbonyl group or a carbamoyl group;
R²¹ represents an oxygen atom, a sulphur atom, a methylene group, or a group -SO-, -SO₂-, -C(CF₃)₂- or -C(CH₃)₂-;
q is a number from 1 to 6, preferably 3;
R²² represents a C₁ - C₄ alkyl group (e.g. methyl, ethyl, propyl or butyl) or an aryl group (e.g. phenyl);
r is a number from 0 to 2000; and
R²³ represents a C₁ - C₄ alkyl group (e.g. methyl, ethyl, propyl or butyl), an aryl group (e.g. phenyl) or a group of formula (X): 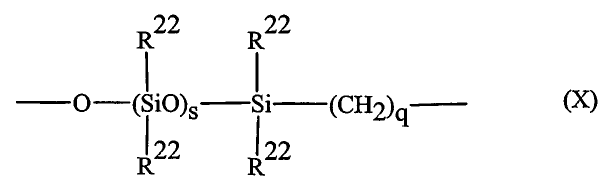 in which R²² and q are as defined above and s is a number from 0 to 100.

Another class of multi-functional oxetanes for use in the compositions of the present invention are linear polymers and copolymers having a plurality of oxetane groups, for example the multifunctional oxetane sold as PNOX, available from Taogosei Co. Ltd.

As well as epoxides and optionally oxetanes, other reactive monomers/oligomers which may be used include the vinyl ethers of polyols [such as triethylene glycol divinyl ether, 1,4-cyclohexane dimethanol divinyl ether and the vinyl ethers of poly(alkylene oxides)]. Examples of vinyl ether functional prepolymers include the urethane-based products supplied by Allied Signal. Similarly, monomers/oligomers containing propenyl ether groups may be used in place of the corresponding compounds referred to above containing vinyl ether groups.

Other reactive species can include styrene derivatives and cyclic esters (such as lactones and their derivatives).

The composition of the present invention also contains a cationic photoinitiator. There is no particular restriction on the particular cationic photoinitiator used, and any cationic photoinitiator known in the art may be employed. Examples of such cationic photoinitiators include sulphonium salts (such as the mixture of compounds available under the trade name UVI6992 from Dow Chemical), thianthrenium salts (such as Esacure 1187 available from Lamberti), iodonium salts (such as IGM 440 from IGM) and phenacyl sulphonium salts. However, particularly preferred cationic photoinitiators are the thioxanthonium salts, such as those described in WO 03/072567 A1, WO 03/072568 A1, and WO 2004/055000 A1, the disclosures of which are incorporated herein by reference.

Particularly preferred thioxanthonium salts are those of formulae (XI), (XII) and (XIII):

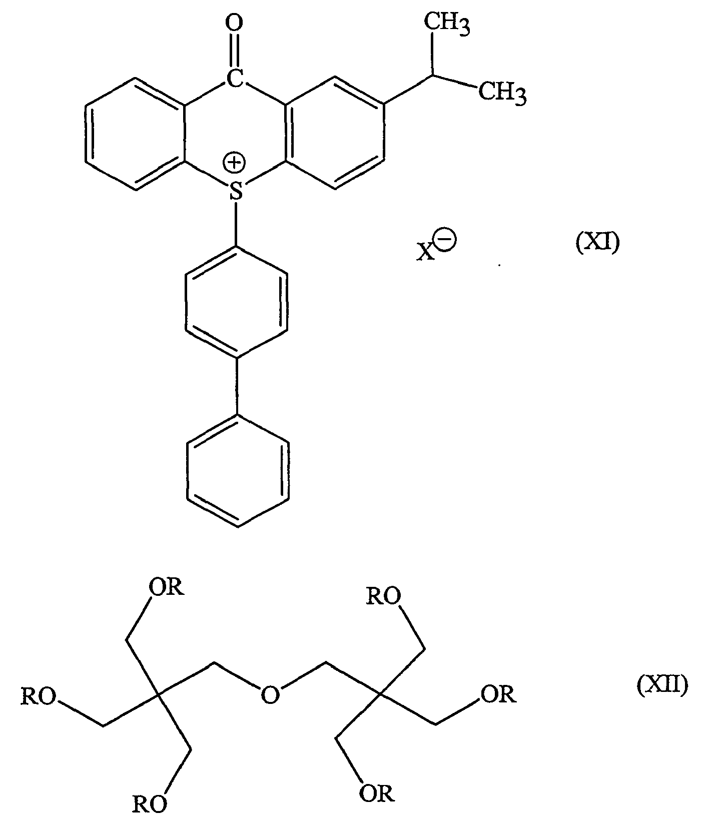

R-(OCH₂CH₂CH₂CH₂)ₙ-OR (XIII)

in which each R represents a group of formula (XIV): 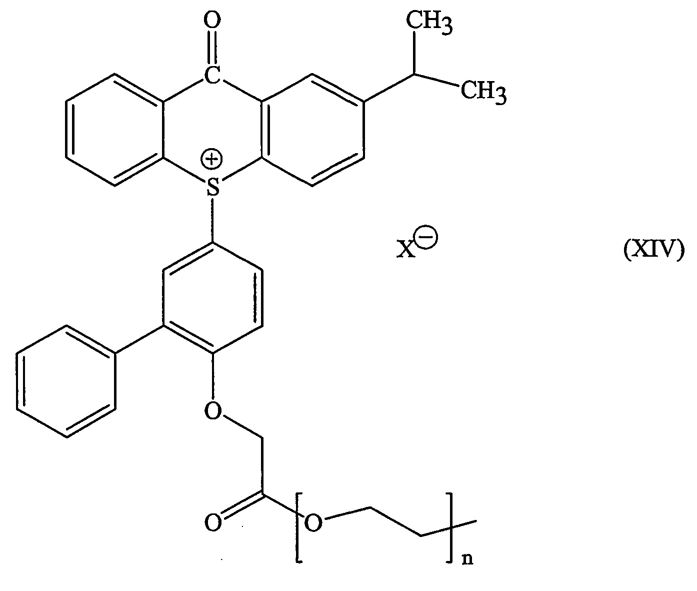 where n is a number and X- is an anion, especially the hexafluorophosphates. The hexafluorophosphates of the compounds of formulae (I) and (II) are available from Robinson Brothers Ltd. under the trade marks "Meerkat" and "Bobcat", respectively, or from IGM under the trade marks IGM 550 and IGM 650 respectively.

The compositions of the present invention also contain a cyclic carbonate at a level higher than is conventionally used, when it is merely present as a solvent for the cationic photoinitiator, i.e. at a level of at least 7% by weight of the entire composition, preferably at least 8% by weight of the entire composition, more preferably at least 10% by weight of the entire composition, and most preferably at least 15% by weight of the entire composition. The amount of cyclic carbonate can go up to very high levels, far beyond what would previously have been considered sensible, even as far as 40% by weight of the entire composition, although, at such a level, its presence will tend to degrade the properties of the cured coating composition, and a more reasonable maximum is 35%, still more preferably 30%. In general, an amount of from 8% to 35% by weight of the entire composition is preferred, more preferably from 10% to 30% by weight of the entire composition, still more preferably from 12% to 25% by weight of the entire composition, and most preferably from 15% to 25% by weight of the entire composition.

The cyclic carbonate used may be any known in the art, preferably one that can act as a solvent for at least some part of the composition of the present invention prior to curing. Preferred cyclic carbonates are those having a 5-membered ring. Examples of suitable cyclic carbonates include compounds of formula (XV): 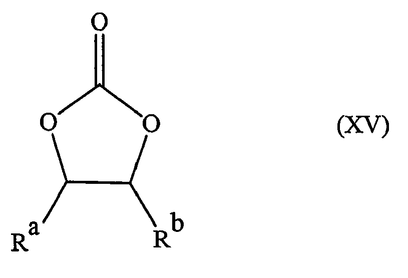 in which R^{a} and R^{b} are the same as or different from each other and each represents a hydrogen atom, a C₁ - C₃ alkyl group, a C₁ - C₃ hydroxyalkyl group or a C₂ - C₃ alkenyl group.

Where R^{a} and/or R^{b} represents an alkyl group, this may be, for example, a methyl, ethyl, propyl or isopropyl group, the methyl group being preferred. Where R^{a} and/or R^{b} represents a hydroxyalkyl group, this may be, for example, a hydroxymethyl, 1-hydroxyethyl, 2-hydroxyethyl, 2-hydroxypropyl or 3-hydroxypropyl group, the hydroxymethyl group being preferred. Where R^{a} and/or R^{b} represents an alkenyl group, this may be a vinyl or allyl group, the vinyl group being preferred.

Specific examples of such cyclic carbonates include propylene carbonate, glycerine carbonate, vinyl ethylene carbonate, ethylene carbonate and butylene carbonate, of which propylene carbonate is preferred.

The composition of the present invention may be formulated as a printing ink, varnish, adhesive, paint or any other coating composition which is intended to be cured by energy, which may be supplied by irradiation, whether by ultraviolet or electron beam. Such compositions will normally contain at least a polymerisable monomer, prepolymer or oligomer, and a cationic photoinitiator, as well as the cyclic carbonate, but may also include other components well known to those skilled in the art, for example, reactive diluents and, in the case of printing inks and paints, a pigment or dye.

It is also common to include polyols in ultraviolet cationic curable formulations, which promote the cross-linking by a chain-transfer process. Examples of polyols include the ethoxylated/propoxylated derivatives of, for example, trimethylolpropane, pentaerythritol, di-trimethylolpropane, di-pentaerythritol and sorbitan esters, as well as more conventional poly(ethylene oxide)s and poly(propylene oxide)s. Other polyols well known to those skilled in the art are the polycaprolactone diols, triols and tetraols, such as those supplied by Dow.

Additives which may be used in conjunction with the principal components of the coating formulations of the present invention include stabilisers, plasticisers, pigments, waxes, slip aids, levelling aids, adhesion promoters, surfactants and fillers.

The amounts of the various components of the curable composition of the present invention may vary over a wide range and, in general, are not critical to the present invention. However, we prefer that the amount of the polymerisable components (i.e. the epoxide, multi-functional oxetane, and other monomers, prepolymers and oligomers, if used) should be from 40 to 90%. The epoxide(s) preferably comprise from 30 to 80% of the polymerisable components in the composition of the present invention, and the multi-functional oxetane(s) preferably comprise from 5 to 40% of the polymerisable components in the composition of the present invention. The amount of cationic photoinitiator is normally from 1.0 to 10% by weight, more preferably from 2.0 to 8%, by weight of the entire composition.

Other components of the curable composition may be included in amounts well known to those skilled in the art.

The curable compositions of this invention may be suitable for applications that include protective, decorative and insulating coatings; potting compounds; sealants; adhesives; photoresists; textile coatings; and laminates. The compositions may be applied to a variety of substrates, e.g., metal, rubber, plastic, wood, moulded parts, films, paper, glass cloth, concrete, and ceramic. The curable compositions of this invention are particularly useful as inks for use in a variety of printing processes, including, but not limited to, flexography, inkjet and gravure. Details of such printing processes and of the properties of inks needed for them are well known and may be found, for example, in The Printing Ink Manual, 5th Edition, edited by R.H. Leach et al., published in 1993 by Blueprint, the disclosure of which is incorporated herein by reference.

Where the compositions of the present invention are used for inks, these typically comprise, as additional components to those referred to above, one or more of pigments, waxes, stabilisers, and flow aids, for example as described in "The Printing Ink Manual".

Thus, the invention also provides a process for preparing a cured coating composition, which comprises applying a composition according to the present invention to a substrate and exposing the coated substrate to curing radiation sufficient to cure the coating.

The invention is further illustrated by the following non-limiting Examples. Percentages are by weight.

### EXAMPLE 1

Varnish formulations were prepared based on 2% Meerkat photoinitiator, 0.1% Tegorad 2100 wetting aid, 30% of an oxetane monomer, variable levels of propylene carbonate, as shown in Tables 1, 2 and 3, with the remainder being UVR6105 cycloaliphatic epoxide. All formulations were printed using a number 1 K bar onto Leneta charts and cured with a single pass at 100 m/minute using 1x 300 W/inch medium pressure mercury lamp operating at half power. Cure was assessed using the well known MEK solvent rub method immediately after cure, 5 minutes after cure and 15 minutes after cure.

**Table 1**

| 30 % of OXT-221 | | | |
|---|---|---|---|
| % propylene carbonate | MEK double rubs | | |
| | Immediate | T= 5 minutes | T= 15 minutes |
| 1 | 5 | 14 | 46 |
| 5 | 8 | > 50 | > 50 |
| 10 | 30 | > 50 | > 50 |
| 12.5 | 25 | > 50 | > 50 |
| 15 | 18 | > 50 | > 50 |
| 20 | 15 | 35 | > 50 |
| 25 | 6 | 18 | 28 |
| 30 | 4 | 18 | 18 |

**Table 2**

| 30 % of OXT-121 | | | |
|---|---|---|---|
| % propylene carbonate | MEK double rubs | | |
| | Immediate | T= 5 minutes | T= 15 minutes |
| 1 | 5 | 5 | 9 |
| 5 | 7 | 19 | 29 |
| 10 | 7 | 37 | > 50 |
| 12.5 | 10 | > 50 | > 50 |
| 15 | 8 | >50 | >50 |
| 20 | 7 | 16 | 37 |
| 25 | 6 | 11 | 18 |
| 30 | 5 | 6 | 11 |

**Table 3**

| 30% of PNOX | | | |
|---|---|---|---|
| % propylene carbonate | MEK double rubs | | |
| | Immediate | T= 5 minutes | T= 15 minutes |
| 1 | 3 | 4 | 6 |
| 5 | 4 | 15 | 45 |
| 10 | 5 | > 50 | > 50 |
| 12.5 | 9 | > 50 | > 50 |
| 15 | 13 | >50 | > 50 |
| 20 | 8 | >50 | > 50 |
| 25 | 6 | 19 | 37 |
| 30 | 5 | 9 | 18 |

| | | | |
|---|---|---|---|
| * coating tacky or wet | | | |

- *The photoinitiator Meerkat (10-biphenyl-4-yl-2-isopropyl-9-oxo-9H-thioxanthen-10-ium hexafluorophosphate) was obtained from Robinson Brothers*
- *Tegorad 2100 is a wetting aid obtained from the Tego Corporation*
- *The cycloaliphatic epoxide resin UVR6105 (3,4-epoxycyclohexylmethyl 3,4-epoxycyclohexane carboxylate) was obtained from DOW*
- *Propylene carbonate was obtained from Aldrich*
- *The di-oxetarze compound OXT-221 (Bis[1-ethyl(3-oxetanyl)]methyl ether) was obtained from Toagosei.*
- *The di-oxetane compound OXT-121 [1,4-Bis(3-ethyl-3-oxetanylmethoxy)methyl] benzene was obtained from Toagosei.*
- *The oxetane functional novolac polymer PNOX was obtained from Toagosei.*

For comparison, the same experiments were carried out, but using no oxetane (replaced by extra epoxide) or a mono-oxetane, either TMPO or OXT-212, in place of the di-oxetanes used above. The results are shown in Tables 4, 5 and 6.

**Table 4**

| No oxetane | | | |
|---|---|---|---|
| % propylene carbonate | MEK double rubs | | |
| | Immediate | T= 5 minutes | T= 15 minutes |
| 1 | 7 | 10 | 11 |
| 5 | 6 | 21 | 30 |
| 10 | 7 | 29 | 48 |
| 15 | 9 | 48 | > 50 |
| 20 | 13 | > 50 | > 50 |
| 25 | 11 | 30 | 46 |
| 30 | 9 | 14 | 22 |
| 40 | 7* | 5 | 9 |
| 50 | 5* | 3* | 5 |

**Table 5**

| 30 % of TMPO | | | |
|---|---|---|---|
| % propylene carbonate | MEK double rubs | | |
| | Immediate | T= 5 minutes | T= 15 minutes |
| 1 | 5 | 11 | 13 |
| 5 | 5 | 20 | 32 |
| 10 | 3 | 24 | 48 |
| 12.5 | 3 | 14 | 29 |
| 15 | 4 | 9 | 13 |
| 20 | 3 * | 6 | 9 |
| 25 | 2 * | 4 | 4 |
| 30 | 2 * | 4 | 3 |

**Table 6**

| 30 % of OXT-212 | | | |
|---|---|---|---|
| % propylene carbonate | MEK double rubs | | |
| | Immediate | T= 5 minutes | T=15 minutes |
| 1 | 4 | 4 | 5 |
| 5 | 4 | 7 | 11 |
| 10 | 6 | 8 | 10 |
| 12.5 | 6 | 8 | 7 |
| 15 | 8 | 10 | 8 |
| 20 | 6 | 6 | 5 |
| 25 | 3 * | 4 | 6 |
| 30 | 3 * | 4 | 3 |

| | | | |
|---|---|---|---|
| * coating tacky or wet | | | |

These results indicate that, whilst the presence of high levels of propylene carbonate (Table 4) will enhance cure, the multifunctional oxetanes OXT-221, OXT-212 and PNOX (Tables 1, 2 and 3) cause the post-cure development to be substantially enhanced still further. The use of OXT-221 in particular demonstrates a substantial further improvement in both immediate cure and post-cure development which is far beyond what would be expected based on the results in Comparative Example 4, where at a level of 30% the effect of OXT-221 on post-cure development is still relatively small. The substantially better curing of formulations containing cycloaliphatic epoxide, multifunctional oxetanes and high levels of propylene carbonate suggest a synergistic relationship.

### EXAMPLE 2

Varnish formulations were prepared based on 2% Meerkat photoinitiator, 0.1% Tegorad 2100 wetting aid, variable levels of both propylene carbonate and the di-oxetane monomer OXT-221, with the remainder being UVR6105 cycloaliphatic epoxide. All formulations were printed using a number 1 K bar onto Leneta charts and cured with a single pass at 100 m/minute using 1x 300 W/inch medium pressure mercury lamp operating at half power. Cure was assessed using the well known MEK solvent rub method immediately after cure. The results are shown in Table 7

**Table 7**

| % propylene carbonate | Immediate MEK double rubs | | | |
|---|---|---|---|---|
| | 0% OXT-221 | 20% OXT-221 | 30% OXT-221 | 40% OXT-221 |
| 1 | 7 | 4 | 5 | 5 |
| 3.5 | | | | 12 |
| 5 | 6 | 5 | 8 | 31 |
| 7.5 | | | | > 50 † |
| 10 | 7 | 6 | 30 † | > 50 † |
| 12.5 | | 14 | 25 | > 50 † |
| 15 | 9 | 24 † | 18 | 13 |
| 17.5 | | 15 | | |
| 20 | 13 † | 8 | 15 | 8 |
| 25 | 11 | 5 | 6 | 9 |
| 30 | 9 | 3 | 7 | 5 |

| | | | | |
|---|---|---|---|---|
| † *Most effective propylene carbonate level for each level of di-oxetane.* | | | | |

These results indicate that increasing levels of OXT-221 in the formulation gives substantial increases in the immediate MEK solvent resistance; which is a good indication of potential curing line speed on press. Also, the optimum level of propylene carbonate in the formulation falls as the concentration of OXT-221 rises, such that the optimum weight ratio of cycloaliphatic epoxide groups : carbonate groups remains relatively unchanged and within the range 3.6 - 6.7: 1. This would suggest that the oxetane functionality does not copolymerise with the carbonate in the same way as the cycloaliphatic epoxide and that di-oxetane is having a purely synergistic effect.

### EXAMPLE 3

Varnish formulations were prepared based on 2% Meerkat photoinitiator, 0.1% Tegorad 2100 wetting aid, variable levels of OXT-221 di-oxetane monomer and propylene carbonate, with the balance of the formulation being UVR6105 cycloaliphatic epoxide. All formulations were printed using a number 1 K bar onto Leneta charts and cured with a single pass at 100 m/minute using 1x 300 W/inch medium pressure mercury lamp operating at half power. Cure was assessed using the well known MEK solvent rub method at various time intervals after cure. The results are shown in Table 8.

**Table 8**

| Time after cure | MEK double rubs | | | |
|---|---|---|---|---|
| | 0% OXT-221 | 0% OXT-221 | 40% OXT-221 | 40% OXT-221 |
| | 0% propylene carbonate | 20% propylene carbonate | 0% propylene carbonate | 10% propylene carbonate |
| Immediate | 3 | 7 | 6 | 96 |
| 1 minute | | 25 | | |
| 2 minutes | 4 | 42 | 14 | > 300 |
| 4 minutes | | 707 | | |
| 15 minutes | 6 | 116 | | |
| 20 minutes | | | 28 | |
| 30 minutes | 7 | 140 | 32 | |
| 2 hours | 6 | 168 | 83 | |
| 18 hours | 13 | > 300 | 140 | |
| 48 hours | 22 | | 220 | |
| 72 hours | 21 | | 270 | |
| 140 hours | 42 | | > 300 | |

These results confirm those seen in Examples 1 and 2 and demonstrate that a correctly formulated mixture of cycloaliphatic epoxide resin, propylene carbonate and di-oxetane monomer has a cure and post-cure response that is substantially better than any 2 components alone.

### EXAMPLE 4

Cyan ink formulations suitable for flexographic printing were prepared based on;

| | |
|---|---|
| 5.0% | Meerkat photoinitiator |
| 15.0% | Sunfast Blue 249-3054 pigment |
| 10.0% | OXT-221 di-oxetane monomer ex Toagosei |
| 6.25 - 24.25% | propylene carbonate |
| 45.75-63.75% | UVR6105 cycloaliphatic epoxide |

All formulations were printed using an "Easiproof" hand anilox coater using a #300/32 anilox onto PET (polyethylene terephthalate) substrate and cured with a single pass at 146 m/minute using 1x 300 W/inch medium pressure mercury lamp operating at full power. Cure was assessed using the well known SPA (isopropyl alcohol) solvent rub method immediately and 24 hours after cure. The results are shown in Table 9.

**Table 9**

| % propylene carbonate | %UVR 6105 | Weight ratio UVR6105: propylene carbonate | IPA rubs | |
|---|---|---|---|---|
| | | | T= immediate | T= 24 hours |
| 6.25 | 63.75 | 10.2 : 1 | 23 | 88 |
| 8.25 | 61.75 | 7.5 : 1 | 32 | 93 |
| 10.25 | 59.75 | 5.8 : 1 | 57 | 195 |
| 12.25 | 57.75 | 4.7 : 1 | 37 | 150 |
| 14.25 | 55.75 | 3.9 : 1 | 31 | 142 |
| 16.25 | 53.75 | 3.3 : 1 | 23 | 100 |
| 18.25 | 51.75 | 2.8 : 1 | 21 | 81 |
| 20.25 | 49.75 | 2.5 : 1 | 17 | 69 |
| 22.25 | 47.75 | 2.2 : 1 | 16 | 59 |
| 24.25 | 45.75 | 1.9 : 1 | 10 | 50 |

These results in Cyan ink formulations demonstrate that, for formulations based on cycloaliphatic epoxide, propylene carbonate and dioxetane monomer, the optimum cure efficiency is obtained at a level of approximately 10.25% by weight of propylene carbonate, corresponding to a weight ratio of 5.8 UVR6105 : 1 propylene carbonate.

### EXAMPLE 5

Black ink formulations suitable for flexographic printing were prepared based on;

| | |
|---|---|
| 5.0% | Meerkat photoinitiator |
| 2.0% | Sunfast Blue 249-3054 pigment |
| 15.0 % | Special Black 250 pigment ex Degussa |
| 2.5% | Polsperse 10 ex Zinchem Benelux |
| 1.0% | Solsperse 32000 pigment dispersion aid ex. Lubrizol |
| 0-20% | OXT-221 dioxetane monomer |
| 2.5-14.9% | propylene carbonate |
| 43.6-72% | UVR6105 cycloaliphatic epoxide |

All formulations were printed using an "Easiproof" hand anilox coater using a #300/32 anilox onto white BOPP substrate and cured with a single pass at 100 m/minute using 1x 300 W/inch medium pressure mercury lamp operating at half power. Cure was assessed using the well known IPA solvent rub method 20 seconds and 15 minutes after cure. The results are shown in Table 10.

**Table 10**

| Component | % composition | | | | |
|---|---|---|---|---|---|
| | A | B | C | D | E |
| OXT-221 | 0 | 0 | 0 | 10 | 20 |
| Propylene carbonate | 2.5 | 6.25 | 14.9 | 12.9 | 10.9 |
| UVR 6105 | 72 | 68.25 | 59.6 | 51.6 | 43.6 |
| Weight ratio UVR6105: propylene carbonate | 29 : 1 | 10.9 : 1 | 4 : 1 | 4 : 1 | 4 : 1 |
| IPA rubs at 20 seconds | 5 | 9 | 29 | 81 | 70 |
| IPA rubs at 15 minutes | 33 | 44 | 96 | > 300 | 245 |

All inks gave tack free cure with a single pass.

The inks C, D and E were also printed on a Timsons T-Flex 500 flexo printing press using a BOPP 30 micron substrate (RB30 ex UCB) and cured using a 600 W/inch medium pressure mercury arc lamp. The maximum cure speed and MEK double rubs after 1 hour are shown in Table 11.

**Table 11**

| Ink sample | Maximum tack free cure speed (ft /min ) | MEK double rubs after 1 hour (500 ft/min) |
|---|---|---|
| C | 450-500 | 20 |
| D | 600 | 53 |
| E | 700 | 79 |

These results in black ink flexo formulations demonstrate that, for a mixture of cycloaliphatic epoxide and propylene carbonate, enhanced properties are obtained at a weight ratio of approximately 4:1. They also demonstrate the significant synergistic boost to the performance if dioxetane monomer is also added whilst maintaining the correct ratio of cycloaliphatic epoxide : propylene carbonate. Typical commercial cationic black inks have been run under similar conditions and have a maximum cure speed of around 250 ft/minute.

### EXAMPLE 6

A varnish formulation suitable for spray applications was prepared based on 2% Meerkat photoinitiator, 0.2% Tegorad 2100 wetting aid, 10% propylene carbonate, 40% OXT-221 dioxetane and 47.9% UVR6105 cycloaliphatic epoxide. This varnish had a measured viscosity of 16.5 seconds on a Ford 4 cup at 20°C.

The varnish was sprayed onto solvent washed uncoated steel panels using a Binks L600 gravity fed spray gun. The coated panels were then passed at 50 and 80 m/minute under a 300 W/inch medium pressure mercury arc lamp operating at full power. At both line speeds the coating cured with a single pass to give a glossy hard tack-free surface.

### EXAMPLE 7

Two varnish formulations suitable for inkjet application using a Piezo drop on demand inkjet head such as Spectra NOVA 256 or SL 128 print modules were prepared. These were printed onto 3 different substrates as a 12 micron thick film using a number 2 K bar;
- polycarbonate (Makrolon GP cIear 099 ex. BAYER)
- acrylic (plexiglass XT clear 20070 ex. Rohm & Haas)
- DiBond (Reynobond 33 white 903 ex. Alcoa)

The prints were cured under a 300 W/inch medium pressure mercury lamp at 42 m/minute. Viscosities were measured using a Brookfield DVII+ viscometer. The results are shown in Table 12.

**Table 12**

| | Formulation A | Formulation B |
|---|---|---|
| OXT-221 dioxetane | 40 | 20 |
| Meerkat photoinitiator | 2 | 2 |
| UVR 6105 cycloaliphatic epoxide | 46.9 | 61.9 |
| Propylene carbonate | 11 | 16 |
| Megaface F479 Fluoro surfactant | 0.1 | 0.1 |
| | | |
| Viscosity at 50°C | 13.0 | 13.9 |

- Megaface F479 *is a Fluoro surfactant ex Dianippon Ink and Chemical Co. Ltd.*

Both varnishes cured well and gave an initial MEK rub resistance of greater than 50. There was no discernable odour on cure.

### EXAMPLE 8

Cyan ink formulations suitable for inkjet printing were prepared based on;

| | |
|---|---|
| 2.5% | Meerkat photoinitiator |
| 2.1 % | Sunfast Blue 249-3054 pigment |
| 0.1 % | Megaface F479 Fluoro surfactant |
| 45.5% | UVR6105 cycloaliphatic epoxide |
| 29.8 - 49.8% | OXT-221 di-oxetane monomer ex Toagosei |
| 0-20% | propylene carbonate |

All formulations were formulated to a viscosity suitable for a Piezo drop on demand inkjet head such as Spectra NOVA 256 or SL 128 print modules. Formulations were printed at 12 microns thickness onto polycarbonate substrate (Makrolon GP cIear 099 ex. BAYER) using a number 2 K bar and were cured with a single pass under a 300 W/inch medium pressure mercury lamp at 42 m/minute. Cure was assessed using the well known MEK solvent rub method 30 seconds and 15 minutes after cure. Viscosities were measured using a Brookfield DVII+ viscometer. The results are shown in Table 13.

**Table 13**

| % propylene carbonate | Weight ratio UVR6105: propylene carbonate | Viscosity@ 50 °C cPs | MEK double rubs | |
|---|---|---|---|---|
| | | | T= 30 seconds | T=15 minutes |
| 0 | - | 15.7 | 6 | 37 |
| 2.5 | 18.2: 1 | 15.2 | 85 | >200 |
| 5 | 9.1: 1 | 14.7 | 156 | >200 |
| 7.5 | 6.1: 1 | 14.0 | 158 | >200 |
| 10 | 4.6: 1 | 13.4 | >200 | >200 |
| 12.5 | 3.6: 1 | 12.6 | 130 | >200 |
| 15 | 3.0: 1 | 12.1 | 79 | 147 |
| 17.5 | 2.6: 1 | 11.8 | 55 | 75 |
| 20 | 2.3: 1 | 11.3 | 46 | 58 |

These results in Cyan inkjet formulations demonstrate that, for formulations based on cycloaliphatic epoxide, propylene carbonate and dioxetane monomer, the optimum cure efficiency is obtained at a level of approximately 10.0% by weight of propylene carbonate, corresponding to a weight ratio of 4.6 UVR6105 : 1 propylene carbonate. The inkjet formulations of this Example all cured substantially faster than equivalent UV curing free radical based inks.

### Comparative Example 1

Varnish formulations were prepared based on 2% Meerkat photoinitiator, 0.1% Tegorad 2100 wetting aid, variable levels of ε-caprolactone with the remainder being UVR6105 cycloaliphatic epoxide. All formulations also contain 1% of propylene carbonate which is used in a photoinitiator concentrate when preparing the samples. All formulations were printed using a number 1 K bar onto Leneta charts and cured with a single pass at 100 m/minute using 1x 300 W/inch medium pressure mercury lamp operating at half power. Cure was assessed using the well known MEK solvent rub method immediately after cure, 5 minutes after cure and 15 minutes after cure. The results are shown in the following Table 14.

**Table 14**

| % e-caprolactone | MEK double rubs | | |
|---|---|---|---|
| | Immediate | T= 5 minutes | T= 15 minutes |
| 0 | 5 | 7 | 12 |
| 2.5 | 6 | 8 | 10 |
| | 5 | 8 | 9 |
| 10 | 5 | 9 | 12 |
| 15 | 5 | 9 | 12 |
| 20 | 5 * | 7 | 11 |
| 25 | 5 * | 7 | 7 |
| 30 | 4 * | 6 | 4 |

| | | | |
|---|---|---|---|
| * coating tacky or wet | | | |

These results indicate that, although ε-caprolactone is an effective diluent with similar viscosity and viscosity reducing power to propylene carbonate, it has no influence on the promotion of post-cure in the printed formulation and, by inference, plays no significant part in the chemical reactions taking place during the initial cure and post-cure processes.

### Comparative Example 2

Varnish formulations were prepared based on 2% Meerkat photoinitiator, 0.1% Tegorad 2100 wetting aid, variable levels of RAPICURE PEPC with the remainder being UVR6105 cycloaliphatic epoxide. All formulations also contain 1% of propylene carbonate which is used in a photoinitiator concentrate when preparing the samples. All formulations were printed using a number 1 K bar onto Leneta charts and cured with a single pass at 100 m/minute using 1x 300 W/inch medium pressure mercury lamp operating at half power. Cure was assessed using the well known MEK solvent rub method immediately after cure, 5 minutes after cure and 15 minutes after cure. The results are shown in the following Table 15.

**Table 15**

| % RAPICURE PEPC | MEK double rubs | | |
|---|---|---|---|
| | Immediate | T= 5 minutes | T= 15 minutes |
| 0 | 4 | 9 | 14 |
| 2.5 | 4 | 7 | 13 |
| 5 | 4 | 10 | 17 |
| 10 | 5 | 8 | 25 |
| 15 | 5 | 10 | 21 |
| 20 | 4 * | 7 | 13 |
| 25 | 4 * | 5 | 7 |
| 30 | 4 * | 4 | 6 |

| | | | |
|---|---|---|---|
| * coating tacky or wet | | | |

### RAPICURE PEPC (propenyl ether of propylene carbonate) was obtained from International Specialty Products (ISP)

These results indicate that, although RAPICURE PEPC is also effective at promoting post-cure in the printed formulation, it is by no means as effective at doing so as simple aliphatic carbonates such as propylene and ethylene carbonate.

### Comparative Example 3

Varnish formulations were prepared based on increasing levels of Meerkat photoinitiator, 0.1% Tegorad 2100 wetting aid and UVR6105 cycloaliphatic epoxide. All formulations contain 4% of propylene carbonate. All formulations were printed using an "Easiproof" hand anilox coater using a #300/41 anilox onto Leneta charts and cured with a single pass at 100 m/minute using 1x 300 W/inch medium pressure mercury lamp operating at half power. Cure was assessed using the well known MEK solvent rub method immediately after cure, 5 minutes after cure and 15 minutes after cure. The results are shown in the following Table 16.

**Table 16**

| % Photoinitiator | MEK double rubs | | |
|---|---|---|---|
| | Immediate | T= 5 minutes | T= 15 minutes |
| 1 | Sample fails to cure | | |
| 1.5 | 5 | 4 | 6 |
| 2 | 5 | 5 | 6 |
| 2.5 | 5 | 10 | 9 |
| 3 | 5 | 7 | 12 |
| 3.5 | 5 | 8 | 12 |
| 4 | 5 | 8 | 14 |
| 4.5 | 6 | 12 | 15 |
| 5 | 5 | 11 | 17 |
| 6 | 5 | 11 | 16 |
| 7 | 5 | 9 | 15 |
| 8 | 5 | 6 | 14 |

These results indicate that at a constant low level of cyclic carbonate the level of photoinitiator has no effect on promoting post-cure in the printed formulations.

### Comparative Example 4

Varnish formulations were prepared based on 2% Meerkat photoinitiator, 0.1% Tegorad 2100 wetting aid, variable levels of the di- oxetane OXT-221, with the remainder being UVR6105 cycloaliphatic epoxide. All formulations also contain 1% of propylene carbonate which is used in a photoinitiator concentrate when preparing the samples. All formulations were printed using a number 1 K bar onto Leneta charts and cured with a single pass at 100 m/minute using 1x 300 W/inch medium pressure mercury lamp operating at half power. Cure was assessed using the well known MEK solvent rub method immediately after cure, 5 minutes after cure and 15 minutes after cure. The results are shown in Table 17.

**Table 17**

| % OXT-221 | MEK double rubs | | |
|---|---|---|---|
| | Immediate | T= 5 minutes | T=15 minutes |
| 0 | 6 | 8 | 11 |
| 10 | 6 | 10 | 20 |
| 20 | 7 | 18 | 25 |
| 30 | 8 | 18 | 46 |
| 40 | 9 | 40 | > 50 |
| 50 | 9 | > 50 | > 50 |
| 60 | 12 | > 50 | > 50 |

These results indicate that OXT-221 has a significant effect on promoting post-cure in the printed formulations, but this only occurs at concentrations of 40% and above and, on a weight for weight basis, is far inferior to cyclic carbonates such as propylene, ethylene or vinyl ethylene carbonate. Immediate MEK double rubs is not substantially affected by the inclusion of high levels of OXT-221.

## Claims

1. An energy-curable coating composition comprising an epoxide monomer or oligomer, a multifunctional oxetane, a cationic photoinitiator and a cyclic carbonate, the cyclic carbonate being present in an amount of at least 12% by weight of the entire composition.

2. A composition according to Claim 1, in which the cyclic carbonate is present in an amount of at least 15% by weight of the entire composition.

3. A composition according to Claim 1, in which the cyclic carbonate is present in an amount of from 12% to 35% by weight of the entire composition.

4. A composition according to Claim 3, in which the cyclic carbonate is present in an amount of from 12% to 30% by weight of the entire composition.

5. A composition according to Claim 4, in which the cyclic carbonate is present in an amount of from 12% to 25% by weight of the entire composition.

6. A composition according to Claim 5, in which the cyclic carbonate is present in an amount of from 15% to 25% by weight of the entire composition.

7. A composition according to any one of the preceding Claims, in which the multifunctional oxetane is a compound of formula (I): 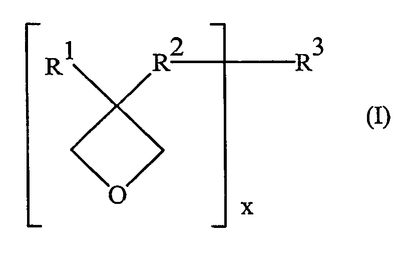 in which:
R¹ represents a hydrogen atom, a C₁ - C₆ alkyl group, an aryl group or an aralkyl group;
R² represents a direct bond or a C₁ - C₆ alkylene group;
R³ represents the residue of a polyol; and
x is a number from 2 to 6.

8. A composition according to Claim 7, in which x is 2.

9. A composition according to any one of Claims 1 to 6, in which the multifunctional oxetane is a compound of formula (II): 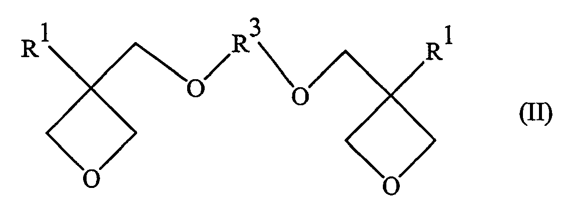 in which:
R¹ represents a hydrogen atom, a C₁ - C₆ alkyl group, an aryl group or an aralkyl group, and the two groups R¹ may be the same as or different from each other; and
R³ represents a C₁ - C₁₂ alkylene group, a C₂ - C₁₂ alkenylene group, a poly(alkyleneoxy) group, a carbonyl group, a C₂ - C₁₂ alkylene group in which a methylene group is replaced by a carbonyl group, an aryl group.

10. A composition according to Claim 9, in which R³ represents a C₁ - C₆ alkylene group.

11. A composition according to any one of Claims 1 to 6, in which the multifunctional oxetane is a compound of formula (III): 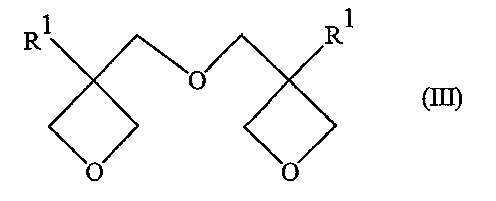 in which R¹ represents a hydrogen atom, a C₁ - C₆ alkyl group, an aryl group or an aralkyl group, and the two groups R¹ may be the same as or different from each other.

12. A composition according to Claim 11, in which the multifunctional oxetane is bis[(1-ethyl-3-oxetanyl)methyl] ether.

13. A composition according to any one of Claims 1 to 6, in which the multifunctional oxetane is a compound of formula (IV): 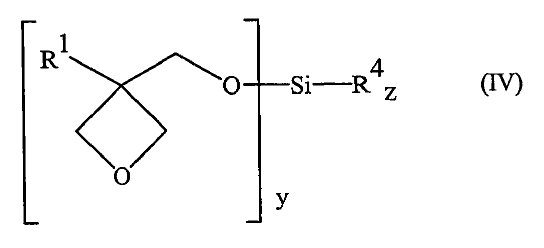 R¹ represents a hydrogen atom, a C₁ - C₆ alkyl group, an aryl group or an aralkyl group;
R⁴ represents a group of formula -O-R⁵ or a group R⁶;
R⁵ represents a C₁ - C₂₀ alkyl group, a C₂ - C₂₀ alkenyl group, an aryl group, an aralkyl group, a polyalkylene oxide group or a poly(lactone) group;
R⁶ represents a C₁ - C₂₀ alkyl group, an aryl group or an aralkyl group;
y is a number greater than 1 and no greater than 4; and
(y+z)=4.

14. A composition according to Claim 13, in which the multifunctional oxetane is a compound of formula (V): 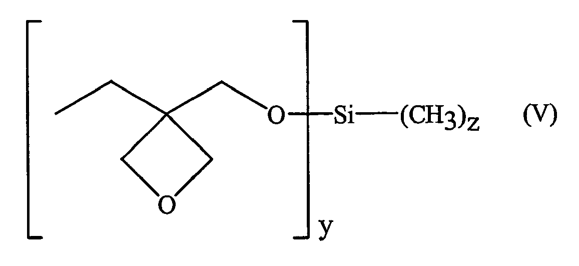 where y is a number of at least 2 and no greater than 4 and z is (4-y).

15. A composition according to any one of the preceding Claims, in which said multi-functional oxetane is a linear polymer or copolymer having a plurality of oxetane groups.

16. A composition according to any one of the preceding Claims, in which the cyclic carbonate is propylene carbonate, glycerine carbonate, vinyl ethylene carbonate, ethylene carbonate or butylene carbonate.

17. A composition according to Claim 16, in which the cyclic carbonate is propylene carbonate.

18. A composition according to any one of the preceding Claims, in the form of a printing ink or varnish.

19. A composition according to any one of the preceding Claims, formulated for inkjet printing.

20. A process for preparing a cured coating composition, which comprises applying a composition according to any one of the preceding Claims to a substrate and exposing the coated substrate to curing radiation sufficient to cure the coating.

21. A process according to Claim 19, in which the curing radiation is ultraviolet.

22. An energy-curable coating composition comprising an epoxide monomer or oligomer, a multifunctional oxetane, a cationic photoinitiator and a cyclic carbonate other than propylene carbonate.

23. A composition according to Claim 22, in which the cyclic carbonate is present in an amount of at least 2% by weight of the entire composition.

24. A composition according to Claim 23, in which the cyclic carbonate is present in an amount of at least 7% by weight of the entire composition.

25. A composition according to Claim 24, in which the cyclic carbonate is present in an amount of at least 8% by weight of the entire composition.

26. A composition according to Claim 25, in which the cyclic carbonate is present in an amount of at least 10% by weight of the entire composition.

27. A composition according to Claim 26, in which the cyclic carbonate is present in an amount of at least 15% by weight of the entire composition.

28. A composition according to Claim 22, in which the cyclic carbonate is present in an amount of from 8% to 35% by weight of the entire composition.

29. A composition according to Claim 28, in which the cyclic carbonate is present in an amount of from 10% to 30% by weight of the entire composition.

30. A composition according to Claim 29, in which the cyclic carbonate is present in an amount of from 12% to 25% by weight of the entire composition.

31. A composition according to Claim 30, in which the cyclic carbonate is present in an amount of from 15% to 25% by weight of the entire composition.

32. A composition according to any one of Claims 22 to 31, in which the multifunctional oxetane is a compound of formula (I): 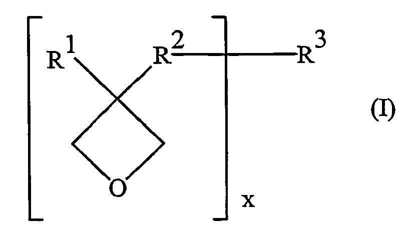 in which:
R¹ represents a hydrogen atom, a C₁ - C₆ alkyl group, an aryl group or an aralkyl group;
R² represents a direct bond or a C₁ - C₆ alkylene group;
R³ represents the residue of a polyol; and
x is a number from 2 to 6.

33. A composition according to Claim 32, in which x is 2.

34. A composition according to any one of Claims 22 to 31, in which the multifunctional oxetane is a compound of formula (II): 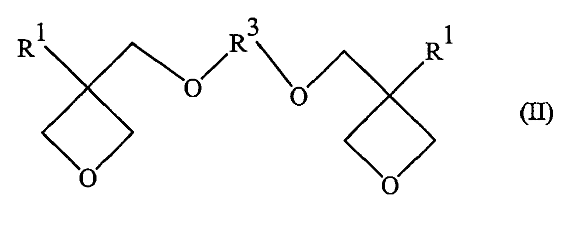 in which:
R¹ represents a hydrogen atom, a C₁ - C₆ alkyl group, an aryl group or an aralkyl group, and the two groups R¹ may be the same as or different from each other; and R³ represents a C₁ - C₁₂ alkylene group, a C₂ - C₁₂ alkenylene group, a poly(alkyleneoxy) group, a carbonyl group, a C₂ - C₁₂ alkylene group in which a methylene group is replaced by a carbonyl group, an aryl group.

35. A composition according to Claim 34, in which R³ represents a C₁ - C₆ alkylene group.

36. A composition according to any one of Claims 22 to 31, in which the multifunctional oxetane is a compound of formula (III): 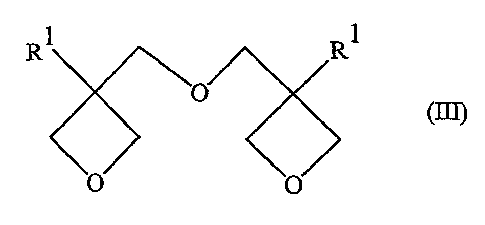 in which R¹ represents a hydrogen atom, a C₁ - C₆ alkyl group, an aryl group or an aralkyl group, and the two groups R¹ may be the same as or different from each other.

37. A composition according to Claim 36, in which the multifunctional oxetane is bis[(1-ethyl-3-oxetanyl)methyl] ether.

38. A composition according to any one of Claims 22 to 31, in which the multifunctional oxetane is a compound of formula (IV): 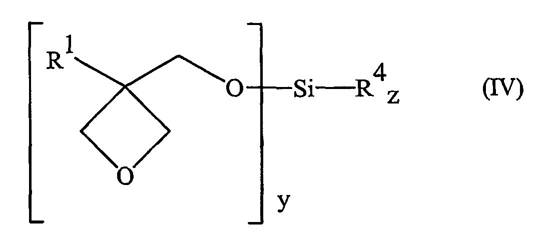 R¹ represents a hydrogen atom, a C₁ - C₆ alkyl group, an aryl group or an aralkyl group;
R⁴ represents a group of formula -O-R⁵ or a group R⁶;
R⁵ represents a C₁ - C₂₀ alkyl group, a C₂ - C₂₀ alkenyl group, an aryl group, an aralkyl group, a polyalkylene oxide group or a poly(lactone) group;
R⁶ represents a C₁ - C₂₀ alkyl group, an aryl group or an aralkyl group;
y is a number greater than 1 and no greater than 4; and
(y+z)=4.

39. A composition according to Claim 38, in which the multifunctional oxetane is a compound of formula (V): 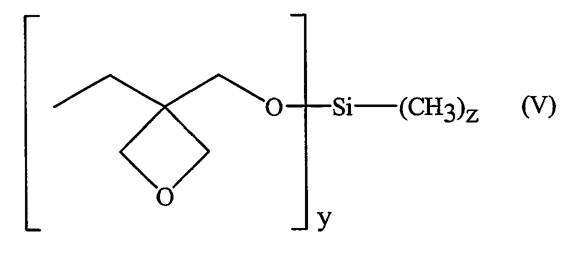 where y is a number of at least 2 and no greater than 4 and z is (4-y).

40. A composition according to any one of Claims 22 to 39, in which said multi-functional oxetane is a linear polymer or copolymer having a plurality of oxetane groups.

41. A composition according to any one of Claims 22 to 40, in which the cyclic carbonate is propylene carbonate, glycerine carbonate, vinyl ethylene carbonate, ethylene carbonate or butylene carbonate.

42. A composition according to any one of Claims 22 to 41, in the form of a printing ink or varnish.

43. A composition according to any one of Claims 22 to 42, formulated for inkjet printing.

44. A process for preparing a cured coating composition, which comprises applying a composition according to any one of Claims 22 to 43 to a substrate and exposing the coated substrate to curing radiation sufficient to cure the coating.

45. A process according to Claim 44, in which the curing radiation is ultraviolet.

46. An energy-curable coating composition comprising an epoxide monomer or oligomer, a multifunctional oxetane, a cationic photoinitiator and a cyclic carbonate, the cyclic carbonate being present in an amount of from 15% to 35% by weight of the entire composition.

## Patentansprüche

1. Energie-aushärtbare Beschichtungszusammensetzung, die ein Epoxidmonomer oder -oligomer, ein multifunktionelles Oxetan, einen kationischen Photoinitiator und ein zyklisches Carbonat umfasst, wobei das zyklische Carbonat in einer Menge von mindestens 12 Gewichtsprozent der gesamten Zusammensetzung vorhanden ist.

2. Zusammensetzung nach Anspruch 1, wobei das zyklische Carbonat in einer Menge von mindestens 15 Gewichtsprozent der gesamten Zusammensetzung vorhanden ist.

3. Zusammensetzung nach Anspruch 1, wobei das zyklische Carbonat in einer Menge von 12 Gewichtsprozent bis 35 Gewichtsprozent der gesamten Zusammensetzung vorhanden ist.

4. Zusammensetzung nach Anspruch 3, wobei das zyklische Carbonat in einer Menge von 12 Gewichtsprozent bis 30 Gewichtsprozent der gesamten Zusammensetzung vorhanden ist.

5. Zusammensetzung nach Anspruch 4, wobei das zyklische Carbonat in einer Menge von 12 Gewichtsprozent bis 25 Gewichtsprozent der gesamten Zusammensetzung vorhanden ist.

6. Zusammensetzung nach Anspruch 5, wobei das zyklische Carbonat in einer Menge von 15 Gewichtsprozent bis 25 Gewichtsprozent der gesamten Zusammensetzung vorhanden ist.

7. Zusammensetzung nach einem der vorstehenden Ansprüche, wobei es sich bei dem multifunktionellen Oxetan um eine Verbindung der Formel (I) handelt: 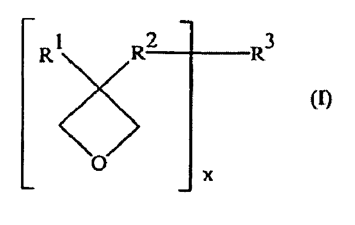 wobei:
R¹ ein Wasserstoffatom, eine C₁-C₆-Alkylgruppe, eine Arylgruppe oder eine Aralkylgruppe darstellt,
R² eine direkte Bindung oder eine C₁-C₆-Alkylengruppe darstellt,
R³ den Rest eines Polyols darstellt und
x eine Zahl von 2 bis 6 ist.

8. Zusammensetzung nach Anspruch 7, wobei x gleich 2 ist.

9. Zusammensetzung nach einem der Ansprüche 1 bis 6, wobei es sich bei dem multifunktionellen Oxetan um eine Verbindung der Formel (II) handelt: 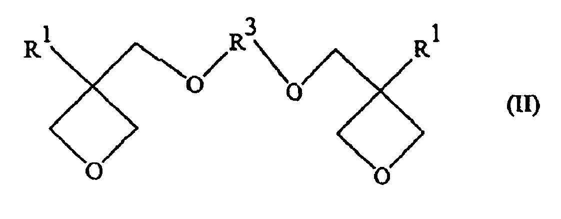 wobei:
R¹ ein Wasserstoffatom, eine C₁-C₆-Alkylgruppe, eine Arylgruppe oder eine Aralkylgruppe darstellt und die beiden R¹-Gruppen gleich oder unterschiedlich sein können und
R³ eine C₁-C₁₂-Alkylengruppe, eine C₂-C₁₂-Alkenylengruppe, eine Poly(alkylenoxy)gruppe, eine Carbonylgruppe, eine C₂-C₁₂-Alkylengruppe, in der eine Methylengruppe durch eine Carbonylgruppe ersetzt ist, eine Arylgruppe darstellt.

10. Zusammensetzung nach Anspruch 9, wobei R³ eine C₁-C₆-Alkylengruppe darstellt.

11. Zusammensetzung nach einem der Ansprüche 1 bis 6, wobei es sich bei dem multifunktionellen Oxetan um eine Verbindung der Formel (III) handelt: 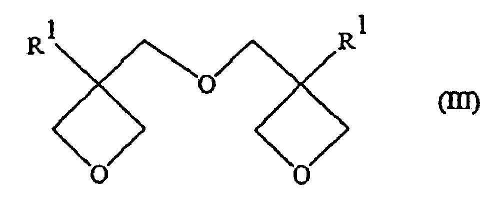 wobei R¹ ein Wasserstoffatom, eine C₁-C₆-Alkylgruppe, eine Arylgruppe oder eine Aralkylgruppe darstellt und die beiden R¹-Gruppen gleich oder unterschiedlich sein können.

12. Zusammensetzung nach Anspruch 11, wobei es sich bei dem multifunktionellen Oxetan um Bis[(1-ethyl-3-oxetanyl)methyl]ether handelt.

13. Zusammensetzung nach einem der Ansprüche 1 bis 6, wobei es sich bei dem multifunktionellen Oxetan um eine Verbindung der Formel (IV) handelt: 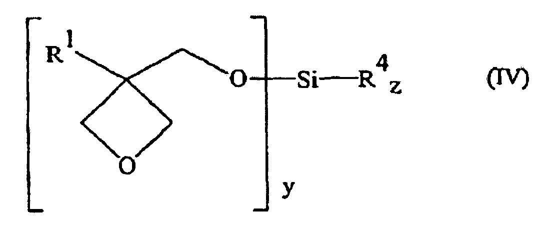 wobei
R¹ ein Wasserstoffatom, eine C₁-C₆-Alkylgruppe, eine Arylgruppe oder eine Aralkylgruppe darstellt,
R⁴ eine Gruppe mit der Formel -O-R⁵ oder eine R⁶-Gruppe darstellt,
R⁵ eine C₁-C₂₀-Alkylgruppe, eine C₂-C₂₀-Alkenylgruppe, eine Arylgruppe, eine Aralkylgruppe, eine Polyalkylenoxidgruppe oder eine Poly(lakton)gruppe darstellt,
R⁶ eine C₁-C₂₀-Alkylgruppe, eine Arylgruppe oder eine Aralkylgruppe darstellt, y eine Zahl ist, die größer als 1 und nicht größer als 4 ist, und (y+z) = 4 ist.

14. Zusammensetzung nach Anspruch 13, wobei es sich bei dem multifunktionellen Oxetan um eine Verbindung der Formel (V) handelt: 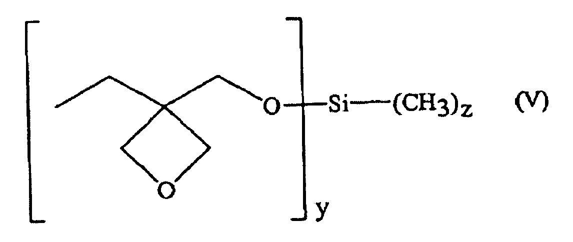 wobei y eine Zahl ist, die mindestens gleich 2 und nicht größer als 4 ist, und z gleich (4-y) ist.

15. Zusammensetzung nach einem der vorstehenden Ansprüche, wobei es sich bei dem multifunktionellen Oxetan um ein lineares Polymer oder Copolymer mit einer Mehrzahl von Oxetangruppen handelt.

16. Zusammensetzung nach einem der vorstehenden Ansprüche, wobei es sich bei dem zyklischen Carbonat um Propylencarbonat, Glyzerincarbonat, Vinylethylencarbonat, Ethylencarbonat oder Butylencarbonat handelt.

17. Zusammensetzung nach Anspruch 16, wobei es sich bei dem zyklischen Carbonat um Propylencarbonat handelt.

18. Zusammensetzung nach einem der vorstehenden Ansprüche in Form einer Drucktinte oder -lacks.

19. Zusammensetzung nach einem der vorstehenden Ansprüche, für den Tintenstrahldruck formuliert.

20. Verfahren zur Zubereitung einer ausgehärteten Beschichtungszusammensetzung, das die Auftragung einer Zusammensetzung nach einem der vorstehenden Ansprüche auf ein Substrat und die Behandlung des beschichteten Substrats mit einer zur Aushärtung der Beschichtung ausreichenden Aushärtungsstrahlung umfasst.

21. Verfahren nach Anspruch 19, wobei es sich bei der Aushärtungsstrahlung um Ultraviolettlicht handelt.

22. Energie-aushärtbare Beschichtungszusammensetzung, die ein Epoxidmonomer oder -oligomer, ein multifunktionelles Oxetan, einen kationischen Photoinitiator und ein zyklisches Carbonat mit Ausnahme von Propylencarbonat umfasst.

23. Zusammensetzung nach Anspruch 22, wobei das zyklische Carbonat in einer Menge von mindestens 2 Gewichtsprozent der gesamten Zusammensetzung vorhanden ist.

24. Zusammensetzung nach Anspruch 23, wobei das zyklische Carbonat in einer Menge von mindestens 7 Gewichtsprozent der gesamten Zusammensetzung vorhanden ist.

25. Zusammensetzung nach Anspruch 24, wobei das zyklische Carbonat in einer Menge von mindestens 8 Gewichtsprozent der gesamten Zusammensetzung vorhanden ist.

26. Zusammensetzung nach Anspruch 25, wobei das zyklische Carbonat in einer Menge von mindestens 10 Gewichtsprozent der gesamten Zusammensetzung vorhanden ist.

27. Zusammensetzung nach Anspruch 26, wobei das zyklische Carbonat in einer Menge von mindestens 15 Gewichtsprozent der gesamten Zusammensetzung vorhanden ist.

28. Zusammensetzung nach Anspruch 22, wobei das zyklische Carbonat in einer Menge von 8 Gewichtsprozent bis 35 Gewichtsprozent der gesamten Zusammensetzung vorhanden ist.

29. Zusammensetzung nach Anspruch 28, wobei das zyklische Carbonat in einer Menge von 10 Gewichtsprozent bis 30 Gewichtsprozent der gesamten Zusammensetzung vorhanden ist.

30. Zusammensetzung nach Anspruch 29, wobei das zyklische Carbonat in einer Menge von 12 Gewichtsprozent bis 25 Gewichtsprozent der gesamten Zusammensetzung vorhanden ist.

31. Zusammensetzung nach Anspruch 30, wobei das zyklische Carbonat in einer Menge von 15 Gewichtsprozent bis 25 Gewichtsprozent der gesamten Zusammensetzung vorhanden ist.

32. Zusammensetzung nach einem der Ansprüche 22 bis 31, wobei es sich bei dem multifunktionellen Oxetan um eine Verbindung der Formel (I) handelt: 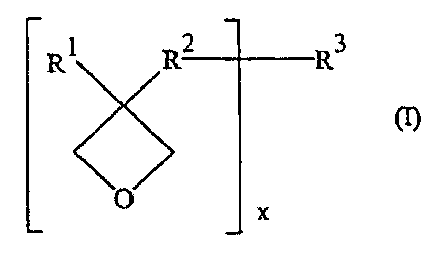 wobei:
R¹ ein Wasserstoffatom, eine C₁-C₆-Alkylgruppe, eine Arylgruppe oder eine Aralkylgruppe darstellt,
R² eine direkte Bindung oder eine C₁-C₆-Alkylengruppe darstellt,
R³ den Rest eines Polyols darstellt und
x eine Zahl von 2 bis 6 ist.

33. Zusammensetzung nach Anspruch 32, wobei x gleich 2 ist.

34. Zusammensetzung nach einem der Ansprüche 22 bis 31, wobei es sich bei dem multifunktionellen Oxetan um eine Verbindung der Formel (II) handelt: 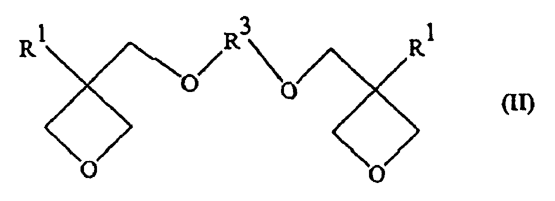 wobei:
R¹ ein Wasserstoffatom, eine C₁-C₆-Alkylgruppe, eine Arylgruppe oder eine Aralkylgruppe darstellt und die beiden R¹-Gruppen gleich oder unterschiedlich sein können und
R³ eine C₁-C₁₂-Alkylengruppe, eine C₂-C₁₂-Alkenylengruppe, eine Poly(alkylenoxy)gruppe, eine Carbonylgruppe, eine C₂-C₁₂-Alkylengruppe, in der eine Methylengruppe durch eine Carbonylgruppe ersetzt ist, eine Arylgruppe darstellt.

35. Zusammensetzung nach Anspruch 34, wobei R³ eine C₁-C₆-Alkylengruppe darstellt.

36. Zusammensetzung nach einem der Ansprüche 22 bis 31, wobei es sich bei dem multifunktionellen Oxetan um eine Verbindung der Formel (III) handelt: 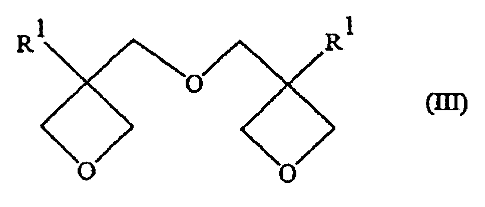 wobei R¹ ein Wasserstoffatom, eine C₁-C₆-Alkylgruppe, eine Arylgruppe oder eine Aralkylgruppe darstellt und die beiden R¹-Gruppen gleich oder unterschiedlich sein können.

37. Zusammensetzung nach Anspruch 36, wobei es sich bei dem multifunktionellen Oxetan um Bis[(1-ethyl-3-oxetanyl)methyl]ether handelt.

38. Zusammensetzung nach einem der Ansprüche 22 bis 31, wobei es sich bei dem multifunktionellen Oxetan um eine Verbindung der Formel (IV) handelt: 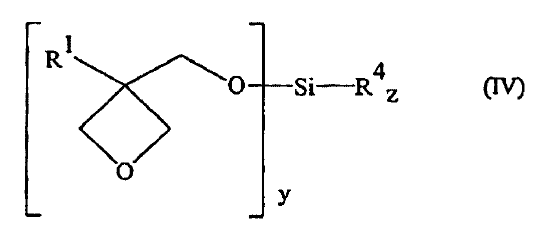 wobei
R¹ ein Wasserstoffatom, eine C₁-C₆-Alkylgruppe, eine Arylgruppe oder eine Aralkylgruppe darstellt,
R⁴ eine Gruppe mit der Formel -O-R⁵ oder eine R⁶-Gruppe darstellt,
R⁵ eine C₁-C₂₀-Alkylgruppe, eine C₂-C₂₀-Alkenylgruppe, eine Arylgruppe, eine Aralkylgruppe, eine Polyalkylenoxidgruppe oder eine Poly(lakton)gruppe darstellt,
R⁶ eine C₁-C₂₀-Alkylgruppe, eine Arylgruppe oder eine Aralkylgruppe darstellt, y eine Zahl ist, die größer als 1 und nicht größer als 4 ist, und
(y+z) = 4 ist.

39. Zusammensetzung nach Anspruch 38, wobei es sich bei dem multifunktionellen Oxetan um eine Verbindung der Formel (V) handelt: 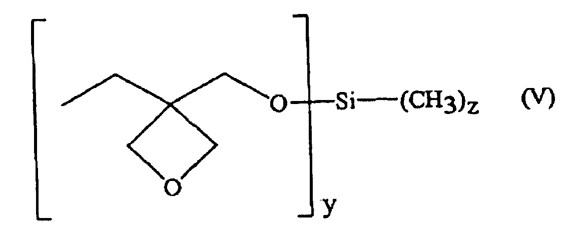 wobei y eine Zahl ist, die mindestens gleich 2 und nicht größer als 4 ist, und z gleich (4-y) ist.

40. Zusammensetzung nach einem der Ansprüche 22 bis 39, wobei es sich bei dem multifunktionellen Oxetan um ein lineares Polymer oder Copolymer mit einer Mehrzahl von Oxetangruppen handelt.

41. Zusammensetzung nach einem der Ansprüche 22 bis 40, wobei es sich bei dem zyklischen Carbonat um Propylencarbonat, Glyzerincarbonat, Vinylethylencarbonat, Ethylencarbonat oder Butylencarbonat handelt.

42. Zusammensetzung nach einem der Ansprüche 22 bis 41 in Form einer Drucktinte oder -lacks.

43. Zusammensetzung nach einem der Ansprüche 22 bis 42, für den Tintenstrahldruck formuliert.

44. Verfahren zur Zubereitung einer ausgehärteten Beschichtungszusammensetzung, das die Auftragung einer Zusammensetzung nach einem der Ansprüche 22 bis 43 auf ein Substrat und die Behandlung des beschichteten Substrats mit einer zur Aushärtung der Beschichtung ausreichenden Aushärtungsstrahlung umfasst.

45. Verfahren nach Anspruch 44, wobei es sich bei der Aushärtungsstrahlung um Ultraviolettlicht handelt.

46. Energie-aushärtbare Beschichtungszusammensetzung, die ein Epoxidmonomer oder -oligomer, ein multifunktionelles Oxetan, einen kationischen Photoinitiator und ein zyklisches Carbonat umfasst, wobei das zyklische Carbonat in einer Menge von 15 Gewichtsprozent bis 35 Gewichtsprozent der gesamten Zusammensetzung vorhanden ist.

## Revendications

1. Composition de revêtement durcissable par énergie comprenant un monomère ou un oligomère d'époxyde, un oxétane multifonctionnel, un photoinitiateur cationique et un carbonate cyclique, le carbonate cyclique étant présent dans une quantité d'au moins 12 % en poids de la composition totale.

2. Composition selon la revendication 1, dans laquelle le carbonate cyclique est présent dans une quantité d'au moins 15 % en poids de la composition totale.

3. Composition selon la revendication 1, dans laquelle le carbonate cyclique est présent dans une quantité de 12 % à 35 % en poids de la composition totale.

4. Composition selon la revendication 3, dans laquelle le carbonate cyclique est présent dans une quantité de 12 % à 30 % en poids de la composition totale.

5. Composition selon la revendication 4, dans laquelle le carbonate cyclique est présent dans une quantité de 12 % à 25 % en poids de la composition totale.

6. Composition selon la revendication 5, dans laquelle le carbonate cyclique est présent dans une quantité de 15 % à 25 % en poids de la composition totale.

7. Composition selon l'une quelconque des revendications précédentes, dans laquelle l'oxétane multifonctionnel est un composé de la formule (I) : 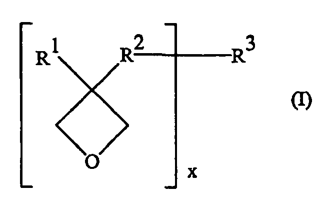 dans laquelle :
R¹ représente un atome d'hydrogène, un groupe alkyle en C₁-C₆, un groupe aryle ou un groupe aralkyle ;
R² représente une liaison directe ou un groupe alkylène en C₁-C₆ ;
R³ représente le résidu d'un polyol ; et
x est un nombre de 2 à 6.

8. Composition selon la revendication 7, dans laquelle x est égal à 2.

9. Composition selon l'une quelconque des revendications 1 à 6, dans laquelle l'oxétane multifonctionnel est un composé de la formule (II) : 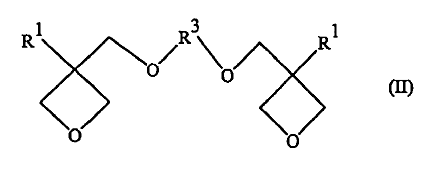 dans laquelle :
R¹ représente un atome d'hydrogène, un groupe alkyle en C₁-C₆, un groupe aryle ou un groupe aralkyle, et les deux groupes R¹ peuvent être identiques ou différents l'un de l'autre ; et
R³ représente un groupe alkylène en C₁-C₁₂, un groupe alcénylène en C₂-C₁₂, un groupe poly(alkylèneoxy), un groupe carbonyle, un groupe alkylène en C₂-C₁₂ dans lequel un groupe méthylène est remplacé par un groupe carbonyle, un groupe aryle.

10. Composition selon la revendication 9, dans laquelle R³ représente un groupe alkylène en C₁-C₆.

11. Composition selon l'une quelconque des revendications 1 à 6, dans laquelle l'oxétane multifonctionnel est un composé de la formule (III) : 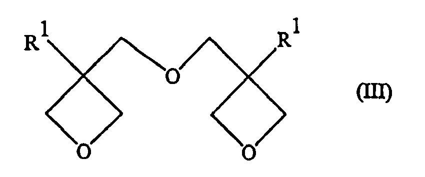 dans laquelle R¹ représente un atome d'hydrogène, un groupe alkyle en C₁-C₆, un groupe aryle ou un groupe aralkyle, et les deux groupes R¹ peuvent être identiques ou différents l'un de l'autre.

12. Composition selon la revendication 11, dans laquelle l'oxétane multifonctionnel est le bis[(1-éthyl-3-oxétanyl)méthyl]éther.

13. Composition selon l'une quelconque des revendications 1 à 6, dans laquelle l'oxétane multifonctionnel est un composé de la formule (IV) : 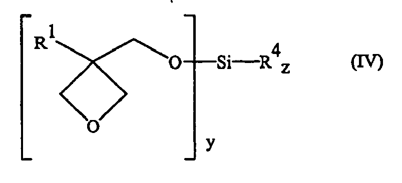 R¹ représente un atome d'hydrogène, un groupe alkyle en C₁-C₆, un groupe aryle ou un groupe aralkyle ;
R⁴ représente un groupe de la formule -O-R⁵ ou un groupe R⁶ ;
R⁵ représente un groupe alkyle en C₁-C₂₀, un groupe alcényle en C₂-C₂₀, un groupe aryle, un groupe aralkyle, un groupe poly(oxyde d'alkylène) ou un groupe poly(lactone) ;
R⁶ représente un groupe alkyle en C₁-C₂₀, un groupe aryle ou un groupe aralkyle ;
y est un nombre supérieur à 1 et d'au plus 4 ; et
(y+z)=4.

14. Composition selon la revendication 13, dans laquelle l'oxétane multifonctionnel est un composé de la formule (V) : 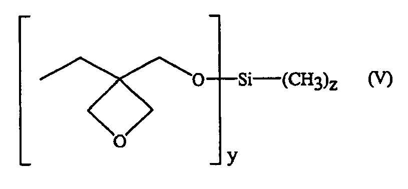 dans laquelle y est un nombre d'au moins 2 et d'au plus 4 et z est égal à (4-y).

15. Composition selon l'une quelconque des revendications précédentes, dans laquelle ledit oxétane multifonctionnel est un polymère ou un copolymère linéaire présentant plusieurs groupes oxétane.

16. Composition selon l'une quelconque des revendications précédentes, dans laquelle le carbonate cyclique est le carbonate de propylène, le carbonate de glycérine, le carbonate de vinyléthylène, le carbonate d'éthylène ou le carbonate de butylène.

17. Composition selon la revendication 16, dans laquelle le carbonate cyclique est le carbonate de propylène.

18. Composition selon l'une quelconque des revendications précédentes, dans la forme d'une encre d'impression ou d'un vernis.

19. Composition selon l'une quelconque des revendications précédentes formulée pour une impression par jet d'encre.

20. Procédé de préparation d'une composition de revêtement durci, lequel comprend l'application d'une composition selon l'une quelconque des revendications précédentes sur un substrat et l'exposition du substrat revêtu à un rayonnement de durcissement suffisant pour faire durcir le revêtement.

21. Procédé selon la revendication 19, dans lequel le rayonnement de durcissement est ultraviolet.

22. Composition de revêtement durcissable par énergie comprenant un monomère ou un oligomère d'époxyde, un oxétane multi-fonctionnel, un photoinitiateur cationique et un carbonate cyclique différent du carbonate de propylène.

23. Composition selon la revendication 22, dans laquelle le carbonate cyclique est présent dans une quantité d'au moins 2 % en poids de la composition totale.

24. Composition selon la revendication 23, dans laquelle le carbonate cyclique est présent dans une quantité d'au moins 7 % en poids de la composition totale.

25. Composition selon la revendication 24, dans laquelle le carbonate cyclique est présent dans une quantité d'au moins 8 % en poids de la composition totale.

26. Composition selon la revendication 25, dans laquelle le carbonate cyclique est présent dans une quantité d'au moins 10 % en poids de la composition totale.

27. Composition selon la revendication 26, dans laquelle le carbonate cyclique est présent dans une quantité d'au moins 15 % en poids de la composition totale.

28. Composition selon la revendication 22, dans laquelle le carbonate cyclique est présent dans une quantité de 8 % à 35 % en poids de la composition totale.

29. Composition selon la revendication 28, dans laquelle le carbonate cyclique est présent dans une quantité de 10 % à 30 % en poids de la composition totale.

30. Composition selon la revendication 29, dans laquelle le carbonate cyclique est présent dans une quantité de 12 % à 25 % en poids de la composition totale.

31. Composition selon la revendication 30, dans laquelle le carbonate cyclique est présent dans une quantité de 15 % à 25 % en poids de la composition totale.

32. Composition selon l'une quelconque des revendications 22 à 31, dans laquelle l'oxétane multifonctionnel est un composé de la formule (I) : 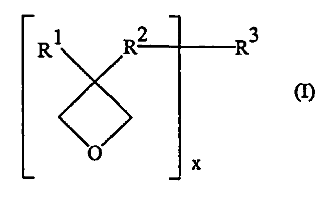 dans laquelle :
R¹ représente un atome d'hydrogène, un groupe alkyle en C₁-C₆, un groupe aryle ou un groupe aralkyle ;
R² représente une liaison directe ou un groupe alkylène en C₁-C₆ ;
R³ représente le résidu d'un polyol ; et
x est un nombre de 2 à 6.

33. Composition selon la revendication 32, dans laquelle x est égal à 2.

34. Composition selon l'une quelconque des revendications 22 à 31, dans laquelle l'oxétane multifonctionnel est un composé de la formule (II) : 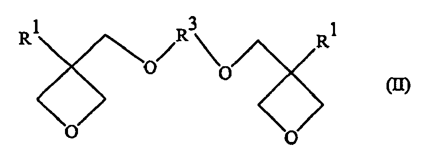 dans laquelle :
R¹ représente un atome d'hydrogène, un groupe alkyle en C₁-C₆, un groupe aryle ou un groupe aralkyle et les deux groupes R¹ peuvent être identiques ou différents l'un de l'autre ; et
R³ représente un groupe alkylène en C₁-C₁₂, un groupe alcénylène en C₂-C₁₂, un groupe poly(alkylèneoxy), un groupe carbonyle, un groupe alkylène en C₂-C₁₂, dans lequel un groupe méthylène est remplacé par un groupe carbonyle, un groupe aryle.

35. Composition selon la revendication 34, dans laquelle R³ représente un groupe alkylène en C₁-C₆.

36. Composition selon l'une quelconque des revendications 22 à 31, dans laquelle l'oxétane multifonctionnel est un composé de la formule (III) : 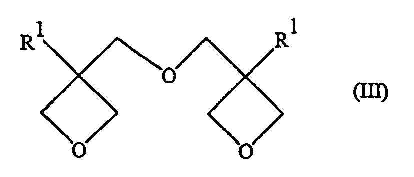 dans laquelle R¹ représente un atome d'hydrogène, un groupe alkyle en C₁-C₆, un groupe aryle ou un groupe aralkyle, et les deux groupes R¹ peuvent être identiques ou différents l'un de l'autre.

37. Composition selon la revendication 36, dans laquelle l'oxétane multifonctionnel est le bis[(1-éthyl-3-oxétanyl)méthyl]éther.

38. Composition selon l'une quelconque des revendications 22 à 31, dans laquelle l'oxétane multifonctionnel est un composé de la formule (IV) : 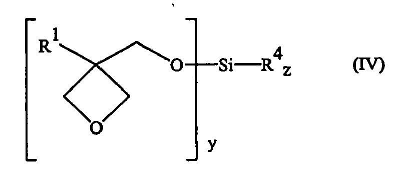 R¹ représente un atome d'hydrogène, un groupe alkyle en C₁-C₆, un groupe aryle ou un groupe aralkyle ;
R⁴ représente un groupe de la formule -O-R⁵ ou un groupe R⁶ ;
R⁵ représente un groupe alkyle en C₁-C₂₀, un groupe alcényle en C₂-C₂₀, un groupe aryle, un groupe aralkyle, un groupe poly(oxyde d'alkylène) ou un groupe poly(lactone) ;
R⁶ représente un groupe alkyle en C₁-C₂₀, un groupe aryle ou un groupe aralkyle ;
y est un nombre supérieur à 1 et d'au plus 4 ; et
(y+z)=4.

39. Composition selon la revendication 38, dans laquelle l'oxétane multifonctionnel est un composé de la formule (V) : 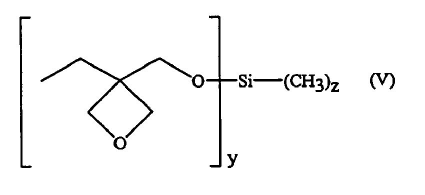 dans laquelle y est un nombre d'au moins 2 et d'au plus 4 et z est égal à (4-y).

40. Composition selon l'une quelconque des revendications 22 à 39, dans laquelle ledit oxétane multifonctionnel est un polymère ou un copolymère linéaire présentant plusieurs groupes oxétane.

41. Composition selon l'une quelconque des revendications 22 à 40, dans laquelle le carbonate cyclique est le carbonate de propylène, le carbonate de glycérine, le carbonate de vinyléthylène, le carbonate d'éthylène ou le carbonate de butylène.

42. Composition selon l'une quelconque des revendications 22 à 41, dans la forme d'une encre d'impression ou d'un vernis.

43. Composition selon l'une quelconque des revendications 22 à 42 formulée pour une impression par jet d'encre.

44. Procédé de préparation d'une composition de revêtement durci, lequel comprend l'application d'une composition selon l'une quelconque des revendications 22 à 43 sur un substrat et l'exposition du substrat revêtu à un rayonnement de durcissement suffisant pour faire durcir le revêtement.

45. Procédé selon la revendication 44, dans lequel le rayonnement de durcissement est ultraviolet.

46. Composition de revêtement durcissable par énergie comprenant un monomère ou un oligomère d'époxyde, un oxétane multifonctionnel, un photoinitiateur cationique et un carbonate cyclique, le carbonate cyclique étant présent dans une quantité de 15 % à 35 % en poids de la composition totale.
